# EUROPÄISCHE PATENTSCHRIFT

(11) **EP 3 381 061 B1**
(45) Veröffentlichungstag und Bekanntmachung des Hinweises auf die Patenterteilung: **24.07.2019**
(21) Anmeldenummer: 16795386.8
(22) Anmeldetag: 16.11.2016
(51) Int. Cl.: H01L 33/46, H01L 33/40, H01L 33/44, H01L 33/14, H01L 33/20

(54) **LEUCHTDIODENCHIP MIT EINER REFLEKTIERENDEN SCHICHTENFOLGE**
LIGHT-EMITTING DIODE CHIP WITH A REFLECTIVE LAYER SEQUENCE
PUCE DE DIODE ÉLECTROLUMINESCENTE AVEC UNE SÉQUENCE DE COUCHES RÉFLÉCHISSANTES

(30) Priorität: 24.11.2015 DE 102015120323
(43) Veröffentlichungstag der Anmeldung: 03.10.2018
(73) Patentinhaber: OSRAM Opto Semiconductors GmbH, 93055 Regensburg (DE)
(72) Erfinder: BAUR, Johannes, 93051 Regensburg (DE); SCHMID, Wolfgang, 93309 Gundelshausen (DE)
(74) Vertreter: Epping - Hermann - Fischer
(86) Internationale Anmeldenummer: PCT/EP2016/077859
(87) Internationale Veröffentlichungsnummer: WO 2017/089198

(56) Entgegenhaltungen:
- EP-A2- 2 743 997
- DE-A1-102010 033 137
- DE-A1-102010 035 966
- DE-A1-102013 103 079

## Beschreibung

Die Erfindung betrifft einen Leuchtdiodenchip mit einer reflektierenden Schichtenfolge, die zwischen einer Halbleiterschichtenfolge und einem Träger des Leuchtdiodenchips angeordnet ist.

Diese Patentanmeldung beansprucht die Priorität der deutschen Patentanmeldung 10 2015 120 323.5.

Es sind so genannte Dünnfilm-Leuchtdiodenchips bekannt, bei denen das ursprüngliche Aufwachssubstrat der Halbleiterschichtenfolge abgelöst und stattdessen die Halbleiterschichtenfolge an einer dem ursprünglichen Aufwachssubstrat gegenüberliegenden Seite mit einem Träger verbunden ist. Die Strahlungsaustrittsfläche des Leuchtdiodenchips ist in diesem Fall an einer dem Träger gegenüberliegenden Oberfläche der Halbleiterschichtenfolge angeordnet, also an der Seite des ursprünglichen Aufwachssubstrats. Bei einem derartigen Dünnfilm-Leuchtdiodenchip ist es vorteilhaft, wenn zwischen dem Träger und der Halbleiterschichtenfolge mindestens eine reflektierende Schicht angeordnet ist, um in die Richtung des Trägers emittierte Strahlung in die Richtung der Strahlungsaustrittsfläche umzulenken und dadurch die Strahlungsausbeute zu erhöhen.

Die Druckschrift DE 10 2005 061 346 A1 beschreibt zum Beispiel eine Dünnfilm-LED, bei der die Spiegelschicht durch eine reflektierende Schichtenfolge gebildet ist, die eine dielektrische Schicht und eine Metallschicht umfasst.

Aus der Druckschrift DE 10 2010 035 966 A1 ist ein optoelektronischer Halbleiterchip bekannt, bei dem zwischen dem Träger und der Halbleiterschichtenfolge eine Spiegelschicht angeordnet ist, wobei die Spiegelschicht zwischen transparenten leitenden Oxidschichten eingebettet ist.

Es hat sich herausgestellt, dass eine reflektierende Schichtenfolge anfällig für Korrosion, insbesondere unter dem Einfluss von Feuchtigkeit, sein kann. Insbesondere an den Grenzflächen in der reflektierenden Schichtenfolge kann das Risiko bestehen, dass sich Spalten bilden und so das Eindringen von Feuchtigkeit begünstigt wird.

Eine zu lösende Aufgabe besteht somit darin, einen Leuchtdiodenchip mit einer reflektierenden Schichtenfolge zwischen dem Träger und der Halbleiterschichtenfolge anzugeben, bei dem die reflektierenden Schichtenfolge besonders gut gegen Korrosion und das Eindringen von Feuchtigkeit geschützt ist.

Diese Aufgabe wird durch einen Leuchtdiodenchip gemäß dem Patentanspruch 1 gelöst. Vorteilhafte Ausgestaltungen und Weiterbildungen der Erfindung sind Gegenstand der abhängigen Ansprüche.

Der Leuchtdiodenchip enthält gemäß zumindest einer Ausführungsform einen Träger und eine Halbleiterschichtenfolge, die vorzugsweise auf einem III-V-Verbindungshalbleitermaterial wie beispielsweise einem Phosphidverbindungshalbleiter, einem Arsenidverbindungshalbleiter, einem Arsenid-Phosphidverbindungshalbleiter oder einem Nitridverbindungshalbleiter basiert.

Besonders bevorzugt basiert die Halbleiterschichtenfolge auf einem Phosphid-Verbindungshalbleitermaterial. "Auf einem Phosphid-Verbindungshalbleitermaterial basierend" bedeutet im vorliegenden Zusammenhang, dass die Halbleiterschichtenfolge oder zumindest eine Schicht davon ein III-Phosphid-Verbindungshalbleitermaterial, vorzugsweise InₓAl_{y}Ga_{1-x-y}P umfasst, wobei 0 ≤ x ≤ 1, 0 ≤ y ≤ 1 und x + y ≤ 1. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die charakteristischen physikalischen Eigenschaften des InₓAl_{y}Ga_{1-x-y}P-Materials im Wesentlichen nicht ändern. Der Einfachheit halber beinhaltet obige Formel jedoch nur die wesentlichen Bestandteile des Kristallgitters (In, Al, Ga, P), auch wenn diese teilweise durch geringe Mengen weiterer Stoffe ersetzt sein können.

Die Halbleiterschichtenfolge enthält insbesondere einen p-Typ Halbleiterbereich, einen n-Typ Halbleiterbereich und eine zwischen dem p-Typ Halbleiterbereich und dem n-Typ Halbleiterbereich angeordnete aktive Schicht zur Emission elektromagnetischer Strahlung. Die aktive Schicht kann insbesondere zur Emission von sichtbarem Licht oder von Nah-Infrarotstrahlung eingerichtet sein.

Die aktive Schicht kann z. B. als pn-Übergang, als Doppelheterostruktur, als Einfach-Quantentopfstruktur oder Mehrfach-Quantentopfstruktur ausgebildet sein. Die Bezeichnung Quantentopfstruktur umfasst dabei jegliche Struktur, bei der Ladungsträger durch Einschluss (confinement) eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte oder Quantenpunkte und jede Kombination dieser Strukturen.

Bei dem Leuchtdiodenchip ist vorzugsweise der n-Typ Halbleiterbereich einer Strahlungsaustrittsfläche des Leuchtdiodenchips zugewandt, und der p-Typ Halbleiterbereich ist dem Träger des Leuchtdiodenchips zugewandt. Vorzugsweise handelt es sich bei dem Leuchtdiodenchip um einen so genannten Dünnfilm-Leuchtdiodenchip, bei dem ein zum Aufwachsen der Halbleiterschichtenfolge verwendetes Aufwachssubstrat von dem Leuchtdiodenchip abgelöst ist. Das ursprüngliche Aufwachssubstrat kann insbesondere vom n-Typ Halbleiterbereich der Halbleiterschichtenfolge abgelöst sein. An der Seite des dem ursprünglichen Aufwachssubstrat gegenüberliebenden p-Typ Halbleiterbereichs ist der Leuchtdiodenchip vorzugsweise mit dem Träger verbunden, beispielsweise mittels einer Lötverbindung. Der Träger ist in diesem Fall von einem Aufwachssubstrat der Halbleiterschichtenfolge verschieden und weist vorzugsweise Silizium, Molybdän oder Germanium auf. Bei dem Leuchtdiodenchip ist vorzugsweise der p-Typ Halbleiterbereich dem Träger und der n-Typ Halbleiterbereich der Strahlungsaustrittsfläche zugewandt.

Zwischen dem Träger und der Halbleiterschichtenfolge ist vorteilhaft eine reflektierende Schichtenfolge angeordnet, die eine der Halbleiterschichtenfolge zugewandte dielektrische Schicht und eine von der Halbleiterschichtenfolge abgewandte metallische Spiegelschicht aufweist. Die reflektierende Schichtenfolge hat insbesondere den Zweck, die aus der aktiven Schicht in Richtung des Trägers emittierte Strahlung zu einer dem Träger gegenüberliegenden Strahlungsaustrittsfläche des Leuchtdiodenchips zurück zu reflektieren.

Die dielektrische Schicht der reflektierenden Schichtenfolge weist vorzugsweise einen Brechungsindex auf, der kleiner als der Brechungsindex des angrenzenden Halbleitermaterials ist. Die dielektrische Schicht bewirkt insbesondere eine Totalreflexion von Strahlung, die unter einem Einfallswinkel auf die Grenzfläche zwischen der Halbleiterschichtenfolge und der dielektrischen Schicht auftrifft, der größer als der Grenzwinkel der Totalreflexion ist. Beispielsweise kann die dielektrische Schicht ein Siliziumoxid oder ein Siliziumnitrid enthalten.

Strahlung, die nicht durch Totalreflexion an der dielektrischen Schicht reflektiert wird, wird vorzugsweise an der metallischen Spiegelschicht in der reflektierenden Schichtenfolge reflektiert. Die metallische Spiegelschicht kann insbesondere Gold enthalten oder daraus bestehen. Alternativ kann die metallische Spiegelschicht auch ein anderes reflektierendes Metall wie zum Beispiel Silber oder Aluminium enthalten oder daraus bestehen.

Gemäß zumindest einer Ausführungsform des Leuchtdiodenchips ist eine Verkapselungsschicht zum Schutz der reflektierenden Schichtenfolge vor Korrosion zumindest stellenweise zwischen dem Träger und der reflektierenden Schichtenfolge angeordnet. Die Verkapselungsschicht erstreckt sich vorteilhaft durch die reflektierende Schichtenfolge hindurch in die Halbleiterschichtenfolge hinein. Insbesondere kann die Verkapselungsschicht in dem p-Typ Halbleiterbereich der Halbleiterschichtenfolge enden, wobei die aktive Schicht nicht von der Verkapselungsschicht durchtrennt wird.

Die reflektierende Schichtenfolge wird von der Verkapselungsschicht insbesondere in einer senkrecht zum Träger verlaufenden Richtung durchtrennt. Die Verkapselungsschicht bildet auf diese Weise vorteilhaft einen Trennsteg aus, der einen Innenbereich der reflektierenden Schichtenfolge von einem Randbereich der reflektierenden Schichtenfolge trennt. Das Merkmal, dass der Trennsteg einen Innenbereich der reflektierenden Schichtenfolge von einem Randbereich der reflektierenden Schichtenfolge trennt und den Innenbereich vollständig umschließt, unterscheidet den Trennsteg insbesondere von gegebenenfalls vorhandenen Kontaktdurchführungen, welche die reflektierende Schichtenfolge nur punktuell durchstoßen, um den Leuchtdiodenchip von der Seite des Trägers aus zu kontaktieren. Solche Kontaktdurchführungen durch die reflektierende Schichtenfolge und/oder Bereiche der Halbleiterschichtenfolge bilden insbesondere keinen Trennsteg aus, der einen Innenbereich von einem Randbereich trennt.

Dadurch, dass ein Randbereich der reflektierenden Schichtenfolge durch den Trennsteg von einem Innenbereich der reflektierenden Schichtenfolge abgetrennt wird, ist der Innenbereich besonders gut gegen Korrosion und das Eindringen von Feuchtigkeit geschützt. Insbesondere wird verhindert, dass sich Risse oder Spalten, die in der reflektierenden Schichtenfolge, insbesondere an Grenzflächen der reflektierenden Schichtenfolge auftreten könnten, bis in den Innenbereich der reflektierenden Schichtenfolge fortsetzen.

Solche Risse oder Spalten könnten das Eindringen von Feuchtigkeit begünstigen. Weiterhin bildet der Trennsteg eine Barriere aus, welche die Ausbreitung von Feuchtigkeit im Schichtmaterial einer der Schichten der reflektierenden Schichtenfolge vermindert. Insbesondere wird die Ausbreitung von Feuchtigkeit in der dielektrischen Schicht wie zum Beispiel einer SiO2-Schicht durch den Trennsteg vermindert.

Bevorzugt umschließt der Trennsteg den Innenbereich vollständig, so dass der Innenbereich insbesondere an keiner Stelle an den Randbereich angrenzt. Der Trennsteg ist mit anderen Worten ein umlaufender Trennsteg, welcher den Innenbereich der reflektierenden Schichtenfolge vollständig von einem Randbereich separiert. Der Trennsteg verläuft insbesondere in einem Abstand entlang sämtlicher Seitenflanken des Leuchtdiodenchips. In Draufsicht bildet der Trennsteg vorteilhaft ein geschlossener Polygonzug, der in einem Abstand entlang der Seitenflanken des Leuchtdiodenchips verläuft. Beispielsweise kann der Trennsteg bei einem rechteckförmigen oder quadratischen Leuchtdiodenchip in Draufsicht in Form eines Rechtecks oder eines Quadrats in einem Abstand entlang der Seitenflanken des Leuchtdiodenchips verlaufen.

Zwischen der dielektrischen Schicht und der metallischen Spiegelschicht ist in der reflektierenden Schichtenfolge vorzugsweise eine Haftschicht angeordnet, die vorzugsweise elektrisch leitend ist. Beispielsweise kann die Haftschicht ein transparentes leitfähiges Oxid (TCO) aufweisen, insbesondere Indiumzinnoxid (ITO). Durch die Haftschicht wird die Haftung zwischen der metallischen Spiegelschicht und der dielektrischen Schicht verbessert.

Durch den Trennsteg, der die reflektierende Schichtenfolge durchtrennt, wird im Fall einer zwischen der metallischen Spiegelschicht und der dielektrischen Schicht angeordneten Haftschicht, die zum Beispiel ITO aufweist, einer Rissbildung an den Grenzflächen zur dielektrischen Schicht und zur metallischen Spiegelschicht vorgebeugt und eine Korrosion der Haftschicht vermindert. Weiterhin wird durch den Trennsteg verhindert, dass die Haftvermittlungswirkung der Haftschicht im Innenbereich durch den Einfluss von Feuchtigkeit vermindert wird.

Bei einer bevorzugten Ausgestaltung des Leuchtdiodenchips weist die Halbleiterschichtenfolge an einer der reflektierenden Schichtenfolge zugewandten Seite zumindest bereichsweise eine Stromaufweitungsschicht auf.
Die Stromaufweitungsschicht ist vorzugsweise eine auf AlGaAs basierende Schicht. Die Stromaufweitungsschicht umfasst insbesondere eine oder mehrere AlₓGa₁₋ₓAs-Schicht(en) mit 0 < x ≤ 1. Bei einem für eine Emission im sichtbaren Spektralbereich vorgesehenen Leuchtdiodenchip gilt vorzugsweise 0,5 < x < 1, besonders bevorzugt 0,6 ≤ x ≤ 0,8. Die Stromaufweitungsschicht ist vorzugsweise p-dotiert.

Bei einer bevorzugten Ausgestaltung wird die Stromaufweitungsschicht wie die reflektierende Schichtenfolge von der Verkapselungsschicht zumindest stellenweise vollständig durchtrennt. Insbesondere ist es möglich, dass der Trennsteg auch die Stromaufweitungsschicht in vertikaler Richtung derart durchtrennt, dass ein Innenbereich der Stromaufweitungsschicht von einem Randbereich der Stromaufweitungsschicht abgetrennt wird. In diesem Fall erstreckt sich der Trennsteg vorteilhaft durch die reflektierende Schichtenfolge und die Stromaufweitungsschicht hindurch bis in die Halbleiterschichtenfolge hinein. Auf diese Weise wird der Innenbereich der Stromaufweitungsschicht besonders gut vor Korrosion geschützt. Diese Ausgestaltung macht sich die Erkenntnis zunutze, dass die Stromaufweitungsschicht insbesondere bei der Verwendung von AlGaAs vergleichsweise anfällig gegenüber Korrosion ist.

Bei dieser Ausgestaltung bildet der Trennsteg vorteilhaft eine Barriere, die die Grenzflächen zwischen der Verkapselungsschicht und der metallischen Spiegelschicht, zwischen der metallischen Spiegelschicht und der gegebenenfalls vorhandenen Haftschicht, zwischen der gegebenenfalls vorhandenen Haftschicht und der dielektrischen Schicht, zwischen der dielektrischen Schicht und der Stromaufweitungsschicht sowie zwischen der Stromaufweitungsschicht und der Halbleiterschichtenfolge in vertikaler Richtung durchtrennt. Der Trennsteg bildet auf diese Weise insbesondere eine Barriere aus, welche die Ausbreitung von Feuchtigkeit, Rissen oder Spalten entlang dieser Grenzflächen effektiv vermindert.

Bei einer bevorzugten Ausgestaltung ist die Verkapselungsschicht eine metallische Schicht. Die Verkapselungsschicht enthält mit anderen Worten mindestens ein Metall oder eine Metalllegierung. Es hat sich herausgestellt, dass eine metallische Schicht eine besonders gute Barriere gegen die Ausbilden oder das Fortschreiten von Rissen oder Spalten entlang von Grenzflächen ausbildet. Weiterhin bildet die Verkapselungsschicht gleichzeitig eine Barriere gegen das Eindringen von Feuchtigkeit. Im Fall einer metallischen Schicht ist die Verkapselungsschicht vorteilhaft eine elektrisch leitfähige Schicht und kann Teil einer elektrisch leitenden Verbindung zwischen dem Träger und der Halbleiterschichtenfolge sein.

Beispielsweise kann der Träger elektrisch leitend sein und mittels einer elektrisch leitfähigen Verbindungsschicht wie beispielsweise einer Lotschicht mit der Verkapselungsschicht verbunden sein. An die Verkapselungsschicht können sich in Richtung der Halbleiterschichtenfolge die metallische Spiegelschicht und eine elektrisch leitende Haftschicht wie beispielsweise eine ITO-Schicht anschließen, wobei die elektrisch leitende Haftschicht mittels Kontaktdurchführungen durch die dielektrische Schicht an die Halbleiterschichtenfolge angeschlossen ist. Die Verkapselungsschicht ist bei dieser Ausgestaltung ein Teil der zur elektrischen Kontaktierung des Leuchtdiodenchips vorgesehenen Schichten. Insbesondere sind im Fall einer metallischen Verkapselungsschicht keine Durchkontaktierungen durch die Verkapselungsschicht erforderlich, um beispielsweise eine elektrisch leitende Verbindungschicht an die metallische Spiegelschicht anzuschließen. Bei der Verwendung einer metallischen Verkapselungsschicht ist daher der Herstellungsaufwand vergleichsweise gering.

Die Verkapselungsschicht enthält vorzugsweise zumindest eines der Metalle Titan, Gold, Platin, Nickel, Wolfram oder zumindest eine Metalllegierung mit mindestens einem dieser Metalle. Die Verkapselungsschicht kann eine Einzelschicht oder eine Schichtenfolge aus mehreren Teilschichten sein, welche jeweils vorzugsweise zumindest eines der genannten Metalle enthalten. Als vorteilhaft hat sich zum Beispiel eine Schichtenfolge aus einer Ti-Schicht und einer TiW-Schicht herausgestellt, wobei die Ti-Schicht der Halbleiterschichtenfolge zugewandt ist. Ti bildet vorteilhaft in den Bereichen, in denen der Trennsteg bis in die Halbleiterschichtenfolge hineinragt, einen vergleichsweise schlechten Anschluss an das Halbleitermaterial. Dies ist vorteilhaft, da eine Stromeinprägung im Randbereich des Leuchtdiodenchips, in dem der Trennsteg verläuft, nicht erwünscht ist, um beispielsweise nicht-strahlende Rekombinationen im Bereich der Seitenflanken des Leuchtdiodenchips zu vermeiden.

Der in die Halbleiterschichtenfolge hineinragende Trennsteg ist insbesondere nicht zum elektrischen Anschluss des Halbleitermaterials in diesem Bereich vorgesehen. Es kann gegebenenfalls sogar vorteilhaft sein, die elektrische Leitfähigkeit des Halbleitermaterials im Bereich des Trennstegs durch zum Beispiel eine Plasmabehandlung zu vermindern, um einen schlechten elektrischen Anschluss des Trennstegs an das Halbleitermaterial zu bewirken. Die elektrische Kontaktierung der Halbleiterschichtenfolge an der dem Träger zugewandten Seite erfolgt vorteilhaft nicht im Bereich des Trennstegs, sondern in dem vom Trennsteg abgetrennten Innenbereich, vorzugsweise durch im Innenbereich angeordnete Kontaktdurchführungen, welche von der metallischen Spiegelschicht und/oder der elektrisch leitfähigen Haftschicht durch die dielektrische Schicht hindurch zu der Halbleiterschichtenfolge geführt sind.

Bei einer alternativen Ausgestaltung ist die Verkapselungsschicht eine dielektrische Schicht, insbesondere eine Oxidschicht. Die dielektrische Schicht ist vorzugsweise zwischen 10 nm und 100 nm dick. Besonders bevorzugt ist die Verkapselungsschicht eine Aluminiumoxidschicht, insbesondere eine Al2O3-Schicht. Im Fall einer dielektrischen Schicht ist die Verkapselungsschicht vorzugsweise eine mittels Atomlagenabscheidung (ALD, Atomic Layer Deposition) abgeschiedene Schicht. Durch Atomlagenabscheidung kann vorteilhaft eine besonders dichte Schicht erzeugt werden, die einen besonders hohen Schutz gegen das Eindringen von Feuchtigkeit bietet. Im Vergleich zur Verwendung einer Metallschicht ist bei der Verwendung einer dielektrischen Verkapselungsschicht allerdings ein erhöhter Herstellungsaufwand erforderlich, da gegebenenfalls Öffnungen zur Herstellung elektrischer Kontaktdurchführungen in der Verkapselungsschicht erzeugt werden müssen. Hierzu ist bei der Herstellung des Leuchtdiodenchips gegebenenfalls ein zusätzlicher Lithografieschritt erforderlich.

Bei einer weiteren bevorzugten Ausgestaltung weist die Halbleiterschichtenfolge an einer dem Träger zugewandten Seite Vertiefungen auf, deren Querschnitt sich in Richtung des Trägers vergrößert. Die Vertiefungen können insbesondere einen prismenförmigen Querschnitt aufweisen. Die vorzugsweise prismenförmigen Vertiefungen haben den Vorteil, dass die Wahrscheinlichkeit für mehrfache Totalreflexionen an den einander gegenüber liegenden Grenzflächen der Halbleiterschichtenfolge vermindert wird. Auf diese Weise kann die Strahlungsauskopplung verbessert und/oder das Winkelspektrum der emittierten Strahlung gezielt beeinflusst werden.

Bei einer Ausgestaltung umfassen die Vertiefungen eine Randvertiefung, die einer Außenseite des Leuchtdiodenchips zugewandt ist. Die Randvertiefung ist mit anderen Worten die der Außenseite des Leuchtdiodenchips am nächsten liegende Vertiefung. Die Randvertiefung kann insbesondere als Randprisma ausgeführt sein, wobei das Randprisma vorzugsweise ein umlaufendes Randprisma ist, das einen Innenbereich des Leuchtdiodenchips vollständig umschließt, beispielsweise ringförmig oder in Form eines geschlossenen Polygons. Der Trennsteg ist vorzugsweise zwischen der Randvertiefung und der Außenseite des Leuchtdiodenchips angeordnet. Dies hat den Vorteil, dass eine Absorption von Strahlung an dem Trennsteg vermindert wird, indem zumindest ein Teil der in Richtung des Trennsteg emittierten Strahlung an der Randvertiefung reflektiert und umgelenkt wird.

Bei einer alternativen Ausgestaltung ist der Trennsteg in der Randvertiefung angeordnet, beispielsweise in der Mitte eines Randprismas. Diese Ausgestaltung hat den Vorteil, dass am Rand des Leuchtdiodenchips kein zusätzlicher Platz für den Trennsteg vorgesehen werden muss. Andererseits wird gegenüber der Anordnung des Trennstegs neben der Randvertiefung eine etwas vergrößerte optische Absorption an dem Trennsteg in Kauf genommen.

Bei einer weiteren alternativen Ausgestaltung weist der Leuchtdiodenchip keine Randvertiefung auf. In diesem Fall ist der Trennsteg vorzugsweise zwischen einer p-Kontaktdurchführung durch die dielektrische Schicht der reflektierenden Schichtenfolge und dem Rand des Leuchtdiodenchips angeordnet. Bei dieser Ausgestaltung ist der Herstellungsaufwand besonders gering und es besteht durch den Verzicht auf die Randvertiefung ein geringer Platzbedarf im Bereich des Rands des Leuchtdiodenchips. Andererseits wird in Richtung des Trennstegs emittierte Strahlung nicht durch eine Randvertiefung umgelenkt und kann so zumindest teilweise an dem Trennsteg absorbiert werden.

Die Erfindung wird im Folgenden anhand von Ausführungsbeispielen im Zusammenhang mit den Figuren 1 bis 4 näher erläutert.

Es zeigen:
- Figur 1: eine schematische Darstellung eines Querschnitts durch einen Leuchtdiodenchip gemäß einem ersten Ausführungsbeispiel,
- Figur 2: eine schematische Darstellung eines Querschnitts durch einen Leuchtdiodenchip gemäß einem zweiten Ausführungsbeispiel,
- Figur 3: eine schematische Darstellung eines Querschnitts durch einen Leuchtdiodenchip gemäß einem dritten Ausführungsbeispiel, und
- Figur 4: eine schematische Darstellung eines Querschnitts durch einen Leuchtdiodenchip gemäß einem vierten Ausführungsbeispiel.

Gleiche oder gleich wirkende Elemente sind in den Figuren mit den gleichen Bezugszeichen versehen. Die Größen der einzelnen Elemente sowie die Größenverhältnisse der Elemente untereinander sind nicht als maßstabsgerecht anzusehen.

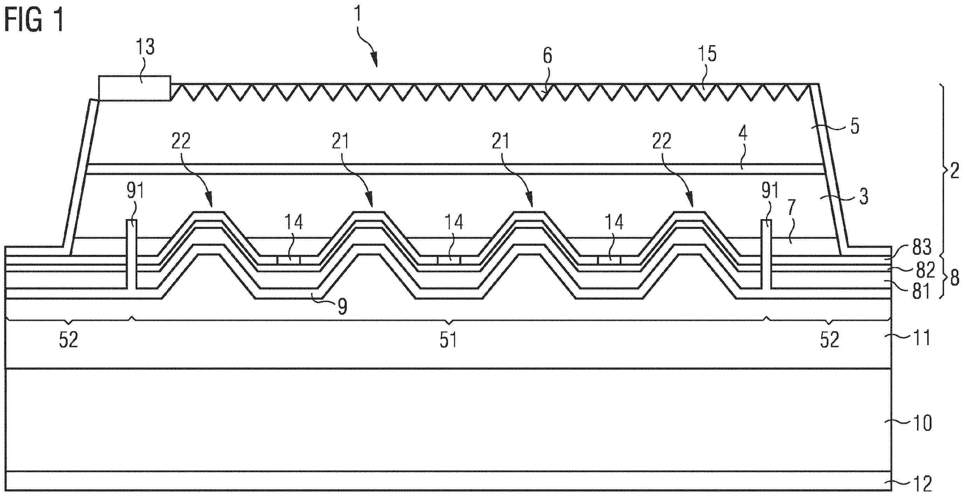

Der in Figur 1 dargestellte Leuchtdiodenchip 1 enthält eine Halbleiterschichtenfolge 2, die einen p-Typ Halbleiterbereich 3 und einen n-Typ Halbleiterbereich 5 aufweist. Zwischen dem p-Typ Halbleiterbereich 3 und dem n-Typ Halbleiterbereich 5 ist eine aktive Schicht 4 angeordnet.

Die aktive Schicht 4 ist insbesondere eine strahlungsemittierende Schicht. Die aktive Schicht 4 kann zum Beispiel als pn-Übergang, als Doppelheterostruktur, als Einfach-Quantentopfstruktur oder Mehrfach-Quantentopfstruktur ausgebildet sein. Die Bezeichnung Quantentopfstruktur umfasst dabei jegliche Struktur, bei der Ladungsträger durch Einschluss (Confinement) eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Die Halbleiterschichtenfolge 2 basiert auf einem III-V-Verbindungshalbleiter. Vorzugsweise basiert die Halbleiterschichtenfolge 2 auf einem PhosphidVerbindungshalbleiter, d. h. die in der Halbleiterschichtenfolge 2 enthaltenen Halbleiterschichten weisen insbesondere InₓGa_{y}Al_{1-x-y}P mit 0 ≤ x ≤ 1, 0 ≤ y ≤ 1 und x + y ≤ 1 auf. Insbesondere enthalten der p-Typ Halbleiterbereich 3, die aktive Schicht 4 und der n-Typ Halbleiterbereich 5 Halbleiterschichten aus Phosphid-Verbindungshalbleitermaterialien.

Bei dem Leuchtdiodenchip 1 handelt es sich um eine sogenannte Dünnfilm-LED, bei der ein zum Aufwachsen der Halbleiterschichtenfolge 2 verwendetes Aufwachssubstrat von der Halbleiterschichtenfolge 2 abgelöst wurde. Insbesondere kann das Aufwachssubstrat von dem n-Typ Halbleiterbereich 5 abgelöst sein, der nun die Strahlungsaustrittsfläche 6 des Leuchtdiodenchips aufweist. Zur Verbesserung der Strahlungsauskopplung kann die Strahlungsaustrittsfläche 6 eine Aufrauhung oder eine Strukturierung aufweisen.

Freiliegende Bereiche der Halbleiterschichtenfolge 2 wie zum Beispiel die Strahlaustrittsfläche 6 und die Seitenflanken des Leuchtdiodenchips 1 können vorteilhaft mit einer Schutzschicht 15 versehen sein, die zum Beispiel ein Siliziumnitrid enthält.

An einer dem ursprünglichen Aufwachssubstrat und der Strahlungsaustrittsfläche 6 gegenüberliegenden Seite ist der Leuchtdiodenchip 1 mit einem Träger 10 verbunden. Der Träger 10 kann zum Beispiel Silizium, Germanium oder Molybdän aufweisen. Bei dem Leuchtdiodenchip 1 ist somit der n-Typ Halbleiterbereich 5 der Strahlungsaustrittsfläche 6 und der p-Typ Halbleiterbereich 3 dem Träger 10 zugewandt. Der Leuchtdiodenchip 1 kann insbesondere mittels einer Verbindungsschicht 11, die beispielsweise eine Lotschicht umfasst, mit dem Träger 10 verbunden sein. Die Verbindungsschicht 11 kann mehrere Teilschichten umfassen, beispielsweise können zusätzlich zu einer Lotschicht Haft- und Benetzungsschichten vorgesehen sein.

Der Träger 10 kann beispielsweise ein elektrisch leitender Träger sein. Bei dieser Ausgestaltung kann zum Beispiel eine erste Kontaktschicht 12 an einer Rückseite des Trägers und eine zweite Kontaktschicht 13, beispielsweise in Form eines Bondpads, an der Strahlungsaustrittsfläche 6 des Leuchtdiodenchips 1 angeordnet sein.

Zwischen dem Träger 10 und dem p-Typ-Halbleiterbereich 3 ist eine Stromaufweitungsschicht 7 angeordnet. Bei der Stromaufweitungsschicht 7 handelt es sich vorzugsweise um eine auf Aluminiumgalliumarsenid basierende Schicht, die insbesondere AlₓGa₁₋ₓAs mit 0 < x ≤ 1 aufweist. Für einen im sichtbaren Spektralbereich emittierenden Leuchtdiodenchip gilt für den Aluminiumanteil x in der Stromaufweitungsschicht 7 vorzugsweise 0,5 < x ≤ 1, besonders bevorzugt 0,6 ≤ x ≤ 0,8. Für einen im infraroten Spektralbereich emittierenden Leuchtdiodenchip kann ein geringerer Aluminiumanteil x in der Stromaufweitungsschicht, beispielsweise x ≤ 0,5 oder x ≤ 0,25, vorteilhaft sein. Die Stromaufweitungsschicht 7 weist vorzugsweise eine Dicke von weniger als 500 nm, bevorzugt von weniger als 300 nm auf.

Alternativ zu AlGaAs kann die Stromaufweitungsschicht 7 ein Phosphidverbindungshalbleitermaterial wie insbesondere GaP aufweisen.

Die Stromaufweitungsschicht 7 ist vorzugsweise p-dotiert und weist bevorzugt eine Dotierstoffkonzentration von mehr als 1 x 10¹⁹ cm⁻³ und besonders bevorzugt von mehr als 5 x 10¹⁹ cm⁻³ auf.

An einer von der Halbleiterschichtenfolge 2 abgewandten Seite die Stromaufweitungsschicht 7 ist eine reflektierende Schichtenfolge 8 angeordnet, welche dazu vorgesehen ist, in Richtung des Trägers 10 emittierte Strahlung in Richtung der Strahlungsaustrittsfläche 6 zu reflektieren. Die reflektierende Schichtenfolge 8 enthält vorzugsweise eine an die Stromaufweitungsschicht 7 angrenzende dielektrische Schicht 83 und zusätzlich eine metallische Spiegelschicht 81. Zwischen der metallischen Spiegelschicht 81 und der dielektrischen Schicht 83 ist vorzugsweise eine Haftschicht 82 angeordnet, die insbesondere ein transparentes leitfähiges Oxid wie zum Beispiel ITO aufweisen kann.

Die dielektrische Schicht 83 kann zum Beispiel eine Siliziumoxidschicht und/oder eine Siliziumnitridschicht umfassen und weist vorteilhaft einen geringeren Brechungsindex als die an sie angrenzende Stromaufweitungsschicht 7 auf. Die Reflexionswirkung der dielektrischen Schicht 83 beruht im Wesentlichen auf dem Effekt der Totalreflexion. In der aktiven Schicht 4 emittierte Strahlung, die unter einem Einfallswinkel auf die Grenzfläche zwischen der Stromaufweitungsschicht 7 und der dielektrischen Schicht 83 auftrifft, der größer ist als der Grenzwinkel der Totalreflexion, wird an der dielektrischen Schicht 83 totalreflektiert.

Weiterhin wird Strahlung, die unter kleineren Einfallswinkeln als dem Grenzwinkel der Totalreflexion auf die dielektrische Schicht 83 auftrifft, durch die dielektrische Schicht 83 und die transparente Haftschicht 82 transmittiert und an der metallischen Spiegelschicht 81 in Richtung der Halbleiterschichtenfolge 2 zurückreflektiert. Die metallische Spiegelschicht umfasst vorzugsweise ein Metall mit einer hohen Reflexion, insbesondere Gold, Aluminium oder Silber. Durch die reflektierende Schichtenfolge 8 wird so eine Verbesserung der Strahlungsausbeute erzielt.

Eine weitere Verbesserung der Strahlungsausbeute wird bei dem Leuchtdiodenchip 1 dadurch erreicht, dass die Halbleiterschichtenfolge 2 an einer dem Träger 10 zugewandten Seite eine Vielzahl von Vertiefungen 21, 22 aufweist, welche eine sich in Richtung des Trägers 10 vergrößernde Querschnittsfläche aufweisen. Die Vertiefungen 21, 22 können insbesondere prismenförmige Vertiefungen sein. Die Vertiefungen 21, 22 können sich zum Beispiel durch die Stromaufweitungsschicht 7 hindurch in den p-Typ Halbleiterbereich 3 hinein erstrecken. Die der Halbleiterschichtenfolge 2 zugewandten schrägen Seitenflächen der Vertiefungen 21, 22 verhindern insbesondere eine mehrfache Totalreflexion innerhalb der Halbleiterschichtenfolge 2, die im Fall von planparallelen Grenzflächen auftreten könnte.

Bei dem Leuchtdiodenchip 1 ist vorteilhaft zwischen dem Träger 10 und der reflektierenden Schichtenfolge 8 eine Verkapselungsschicht 9 angeordnet. Die Verkapselungsschicht 9 grenzt vorzugsweise an die metallische Spiegelschicht 81 an. Insbesondere kann die Verkapselungsschicht 9 zwischen der Verbindungsschicht 11, welche den Leuchtdiodenchip 1 mit dem Träger 10 verbindet, und der metallischen Spiegelschicht 81 angeordnet sein.

Die Verkapselungsschicht 9 ist vorzugsweise eine metallische Schicht. Die metallische Verkapselungsschicht 9 kann eine Einzelschicht sein oder mehrere Teilschichten aufweisen. Insbesondere kann die metallische Verkapselungsschicht 9 eine oder mehrere Schichten aus Ti, TiW, TiW(N), Au, Pt, Ni, NiAu, oder PtAu aufweisen. Besonders vorteilhaft ist zum Beispiel eine Ti-TiW Schichtenfolge, wobei die Ti-Schicht der Halbleiterschichtenfolge zugewandt ist.

Die Verkapselungsschicht 9 umfasst vorteilhaft einen Trennsteg 91, der sich bereichsweise durch die reflektierende Schichtenfolge 8 und die Stromaufweitungsschicht 7 hindurch bis in die Halbleiterschichtenfolge 2 erstreckt. Der Trennsteg 91 erstreckt sich insbesondere bis in den p-Halbleiterbereich 3 hinein. Die aktive Schicht 4 und der n-Typ Halbleiterbereich 5 werden von dem Trennsteg 91 aber nicht durchtrennt.

Durch den Trennsteg 91 wird ein Randbereich 52 der reflektierenden Schichtenfolge 8 und der Stromaufweitungsschicht 7 von einem Innenbereich 51 der reflektierenden Schichtenfolge 8 und der Stromaufweitungsschicht 7 getrennt. Der Trennsteg 91 ist insbesondere ein umlaufender Trennsteg, welcher den Randbereich 52 vollständig von dem Innenbereich 51 separiert. Die Randbereiche 52 der Stromaufweitungsschicht 7 und der reflektierenden Schichtenfolge 8 grenzen vorzugsweise an keiner Stelle an den Innenbereich 51 an. Der Trennsteg 91 verhindert dadurch effektiv das Eindringen von Feuchtigkeit und das Fortschreiten von Korrosion aus dem Randbereich 52 in den Innenbereich 51. Insbesondere werden die Grenzflächen zwischen den Schichten 81, 82, 83 der reflektierenden Schichtenfolge 8, der Stromaufweitungsschicht 7 und dem p-Typ Halbleiterbereich 3 von den Trennsteg 91 vollständig durchtrennt. Der Trennsteg bildet an den Grenzflächen somit eine in senkrechter Richtung verlaufenden Barriere, welche das Fortschreiten einer eventuellen Spaltbildung an diesen Grenzflächen verhindert. Der Innenbereich 51 der reflektierenden Schichtenfolge 8 sowie der Stromaufweitungsschicht 7 ist daher besonders gut gegen Korrosion, Spaltbildung und/oder das Eindringen von Feuchtigkeit geschützt.

Der metallische Trennsteg 91 ragt zwar in die Halbleiterschichtenfolge 2 hinein, ist aber vorzugsweise nicht zur elektrischen Kontaktierung der Halbleiterschichtenfolge 2 vorgesehen. Ein elektrischer Anschluss des Trennstegs 91 an das Halbleitermaterial ist deshalb unerwünscht, da dadurch eine verstärkte Stromeinprägung in den Randbereich der Halbleiterschichtenfolge 2 erfolgen würde. Ein erhöhter Stromfluss im Randbereich des Leuchtdiodenchips 1 ist aber nicht zweckmäßig, da im Randbereich vermehrt nicht-strahlende Rekombinationen auftreten können. Das der Halbleiterschichtenfolge 2 zugewandte Material der Verkapselungsschicht 9 und des Trennstegs 91 ist daher vorzugsweise ein Material, das keinen guten elektrischen Anschluss zur Halbleiterschichtenfolge 2 ausbildet. Bei einer auf InGaAlP basierenden Halbleiterschichtenfolge 2 ist zum Beispiel Titan besonders gut als Material für die Verkapselungsschicht geeignet, da Titan keinen guten Kontakt zu einem InGaAlP-Halbleitermaterial ausbildet.

Die Kontaktierung des p-Typ Halbleiterbereichs 3 erfolgt bei dem Leuchtdiodenchip 1 vielmehr im Innenbereich 51. Hierzu sind p-Kontaktdurchführungen 14 von der elektrisch leitenden Haftschicht 82 durch die dielektrische Schicht 83 hindurch zu der Stromaufweitungsschicht 7 geführt, die an den p-Typ Halbleiterbereich 3 anschließt.

Bei dem Ausführungsbeispiel der Figur 1 weisen die Vertiefungen 21, 22 eine Randvertiefung 22 auf, welche den Seitenflanken des Leuchtdiodenchips 1 zugewandt ist. Der Trennsteg 91 ist vorzugsweise zwischen der Randvertiefung 22 und der Seitenflanke des Leuchtdiodenchips 1 angeordnet. Die Randvertiefung 22 schirmt den Trennsteg 91 auf diese Weise zumindest teilweise von der in der aktiven Schicht 4 emittierten Strahlung ab und vermindert auf diese Weise die Absorption von Strahlung an dem Trennsteg 91.

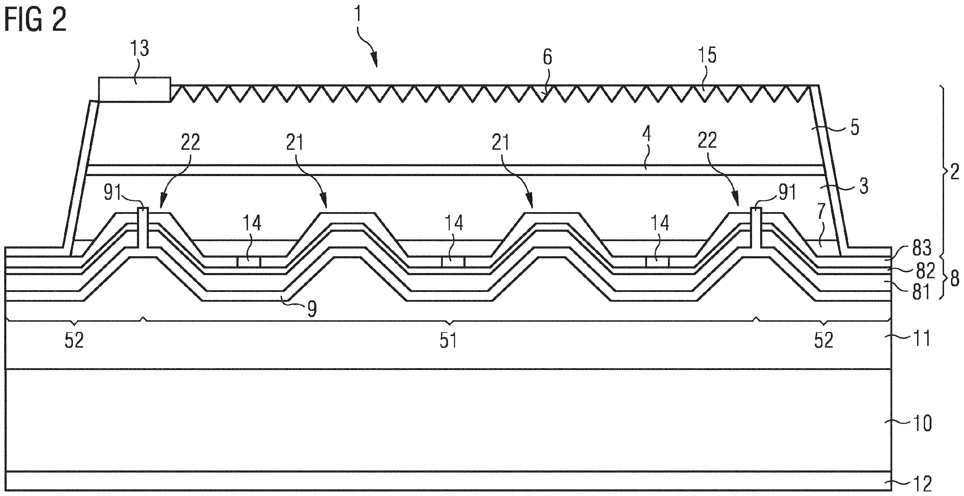

In Figur 2 ist ein weiteres Ausführungsbeispiel des Leuchtdiodenchips 1 dargestellt, das sich von dem in Figur 1 dargestellten Ausführungsbeispiel dadurch unterscheidet, dass der Trennsteg 91 in einer Randvertiefung 22 angeordnet ist.

Diese Ausgestaltung hat den Vorteil, dass neben der Randvertiefung 22 weniger Platz am Rand des Leuchtdiodenchips 1 benötigt wird. Dies ermöglicht es, die Randvertiefung 22 noch näher am Rand des Leuchtdiodenchips 1 anzuordnen, was eine effektivere Nutzung der Fläche des Leuchtdiodenchips ermöglicht. Weiterhin muss bei dieser Ausgestaltung bei der Herstellung des Leuchtdiodenchips 1 kein separater Ätzprozess durchgeführt werden, um eine Öffnung in der Stromaufweitungsschicht 7 für den Trennsteg 91 zu erzeugen. Dies ist nicht erforderlich, weil bereits die Randvertiefung 22 die Stromaufweitungsschicht 7 durchdringt. Da bereits die Randvertiefung 22 die Stromaufweitungsschicht 7 in vertikaler Richtung durchtrennt, ist dies auch für den innerhalb der Randvertiefung angeordneten Trennsteg 91 der Fall.

Hinsichtlich weiterer Details und vorteilhaften Ausgestaltungen entspricht das in Figur 2 dargestellte Ausführungsbeispiel dem ersten Ausführungsbeispiel.

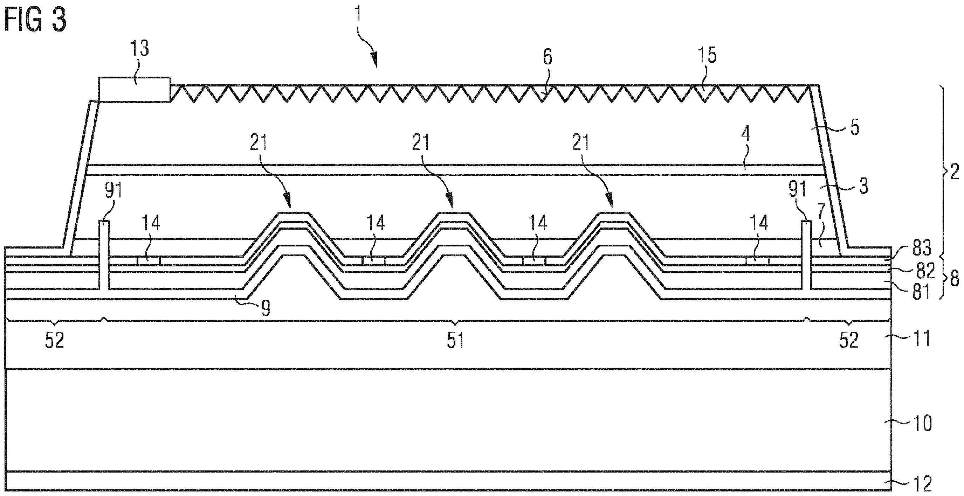

In Figur 3 ist ein weiteres Ausführungsbeispiel des Leuchtdiodenchips 1 dargestellt, bei dem im Vergleich zu den vorherigen Ausführungsbeispielen auf Randvertiefungen 22 verzichtet wurde. Der Leuchtdiodenchip 1 der Figur 3 weist nur im Innenbereich des Leuchtdiodenchips 1 Vertiefungen 21 auf. Weiterhin wird es auch möglich, bei dem Leuchtdiodenchip 1 ganz auf Vertiefungen 21 zu verzichten (nicht dargestellt). Durch den Verzicht auf die Randvertiefungen 22 vergrößert sich der Platz am Rand des Leuchtdiodenchips, so dass dort beispielsweise zusätzliche p-Kontaktdurchführungen 14 angeordnet werden können. Der Trennsteg 91 kann bei dieser Ausgestaltung in der Nähe der Seitenflanke des Leuchtdiodenchips 1 angeordnet sein, beispielsweise in der Nähe einer p-Kontaktdurchführung 14.

Hinsichtlich weiterer Details und vorteilhaften Ausgestaltungen entspricht das in Figur 3 dargestellte Ausführungsbeispiel dem ersten Ausführungsbeispiel.

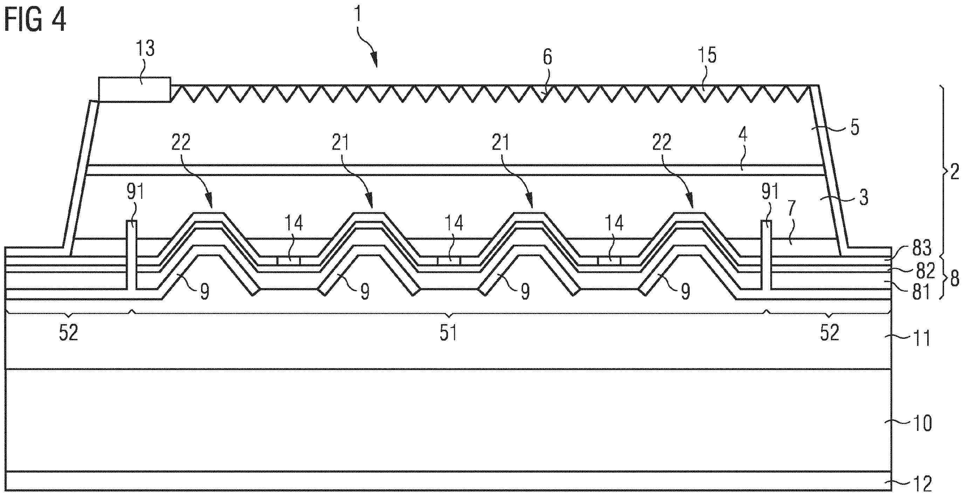

In Figur 4 ist noch ein weiteres Ausführungsbeispiel des Leuchtdiodenchips 1 dargestellt. Der Leuchtdiodenchip 1 ist im Wesentlichen wie bei dem Ausführungsbeispiel der Figur 1 ausgeführt, allerdings handelt es sich bei der Verkapselungsschicht 9 bei diesem Ausführungsbeispiel nicht um eine metallische Verkapselungsschicht, sondern um eine dielektrische Verkapselungsschicht. Insbesondere ist auch der Trennsteg 91, der Bestandteil der Verkapselungsschicht 9 ist, bei dieser Ausgestaltung aus einem dielektrischen Material gebildet. Die dielektrische Schicht, welche die Verkapselungsschicht 9 ausbildet, ist bei dieser Ausgestaltung vorzugsweise zwischen 10 nm und 100 nm dick.

Besonders bevorzugt ist die dielektrische Schicht eine mittels Atomlagenabscheidung (ALD) hergestellte Schicht. Besonders geeignet als Material die dielektrische Verkapselungsschicht ist Aluminiumoxid, insbesondere Al2O3. Aluminiumoxid ist vorteilhaft für die emittierte Strahlung transparent, so dass vorteilhaft an dem Trennsteg 91 keine Absorption der emittierten Strahlung erfolgt. Da die dielektrische Verkapselungsschicht 9 bei dieser Ausgestaltung nicht elektrisch leitfähig ist, kann es allerdings erforderlich sein, die dielektrische Verkapselungsschicht stellenweise zu unterbrechen, um einen elektrischen Kontakt zwischen der metallischen Spiegelschicht 83, welche an den p-Halbleiterbereich 3 angeschlossen ist, und den rückseitigen elektrisch leitfähigen Schichten wie der Verbindungsschicht 11, dem Träger 10 und der ersten Kontaktschicht 12, herzustellen. Hierzu kann ein zusätzlicher lithografischer Prozess erforderlich sein, wodurch sich der Herstellungsaufwand für dieses Ausführungsbeispiel im Vergleich zu den vorherigen Ausführungsbeispielen erhöht. Hinsichtlich weiterer Details und vorteilhaften Ausgestaltungen entspricht das in Figur 4 dargestellte Ausführungsbeispiel dem ersten Ausführungsbeispiel.

### Bezugszeichenliste

- 1: Leuchtdiodenchip
- 2: Halbleiterschichtenfolge
- 3: p-Typ Halbleiterbereich
- 4: aktive Schicht
- 5: n-Typ Halbleiterbereich
- 6: Strahlungsaustrittsfläche
- 7: Stromaufweitungsschicht
- 8: reflektierende Schichtenfolge
- 9: Verkapselungsschicht
- 10: Trägersubstrat
- 11: Verbindungsschicht
- 12: erste Kontaktschicht
- 13: zweite Kontaktschicht
- 14: p-Kontaktdurchführungen
- 15: Schutzschicht
- 21: Vertiefung
- 22: Randvertiefung
- 51: Innenbereich
- 52: Außenbereich
- 81: metallische Spiegelschicht
- 82: Haftschicht
- 82: dielektrische Schicht
- 91: Trennsteg

## Patentansprüche

1. Leuchtdiodenchip (1) mit
- einem Träger (10),
- einer Halbleiterschichtenfolge (2),
- einer reflektierenden Schichtenfolge, die bereichsweise zwischen dem Träger (10) und der Halbleiterschichtenfolge (2) angeordnet ist, und
- einer Verkapselungsschicht (9), die stellenweise zwischen dem Träger (10) und der reflektierenden Schichtenfolge (8) angeordnet ist,
**dadurch gekennzeichnet, dass**
- die reflektierende Schichtenfolge (8) eine der Halbleiterschichtenfolge (2) zugewandte dielektrische Schicht (83) und eine von der Halbleiterschichtenfolge (2) abgewandte metallische Spiegelschicht (81) aufweist, und
- sich die Verkapselungsschicht (9) stellenweise durch die reflektierende Schichtenfolge (8) hindurch in die Halbleiterschichtenfolge (2) hinein erstreckt und auf diese Weise einen Trennsteg (91) ausbildet, der einen Innenbereich (51) der reflektierenden Schichtenfolge (8) von einem Randbereich (52) der reflektierenden Schichtenfolge (8) trennt.

2. Leuchtdiodenchip nach Anspruch 1,
wobei der Trennsteg (91) den Innenbereich (51) vollständig umschließt, so dass der Innenbereich (51) an keiner Stelle an den Randbereich (52) angrenzt.

3. Leuchtdiodenchip nach einem der vorhergehenden Ansprüche,
wobei zwischen der metallischen Spiegelschicht (81) und der dielektrischen Schicht (83) eine Haftschicht (82) angeordnet ist.

4. Leuchtdiodenchip nach einem der vorhergehenden Ansprüche,
wobei die Haftschicht (82) ein transparentes leitfähiges Oxid aufweist.

5. Leuchtdiodenchip nach einem der vorhergehenden Ansprüche,
wobei die Halbleiterschichtenfolge eine Stromaufweitungsschicht (7) umfasst, die an einer der reflektierenden Schichtenfolge (8) zugewandten Seite der Halbleiterschichtenfolge (2) angeordnet ist, wobei die Stromaufweitungsschicht (7) von dem Trennsteg (91) durchtrennt wird.

6. Leuchtdiodenchip nach Anspruch 5,
wobei die Stromaufweitungsschicht (7) auf AlGaAs oder GaP basiert.

7. Leuchtdiodenchip nach einem der vorhergehenden Ansprüche,
wobei die Verkapselungsschicht (9) eine metallische Schicht ist.

8. Leuchtdiodenchip nach einem der vorhergehenden Ansprüche,
wobei die Verkapselungsschicht (9) zumindest eines der Metalle Ti, Au, Pt, Ni, W oder zumindest eine Verbindung mit mindestens einem dieser Metalle aufweist.

9. Leuchtdiodenchip nach einem der vorhergehenden Ansprüche,
wobei die Verkapselungsschicht (9) eine Ti-Schicht umfasst, welche der Halbleiterschichtenfolge (2) zugewandt ist.

10. Leuchtdiodenchip nach einem der Ansprüche 1 bis 6,
wobei die Verkapselungsschicht (9) eine dielektrische Schicht ist.

11. Leuchtdiodenchip nach Anspruch 10,
wobei die Verkapselungsschicht (9) Al₂O₃ aufweist.

12. Leuchtdiodenchip nach Anspruch 10 oder 11,
wobei die Verkapselungsschicht (9) mittels Atomlagenabscheidung hergestellt ist.

13. Leuchtdiodenchip nach einem der vorhergehenden Ansprüche,
wobei die Halbleiterschichtenfolge (2) an einer dem Träger (10) zugewandten Seite Vertiefungen (21, 22) aufweist, deren Querschnitt sich in Richtung des Trägers (10) vergrößert.

14. Leuchtdiodenchip nach Anspruch 13,
wobei die Vertiefungen (21, 22) einen prismenförmigen Querschnitt aufweisen.

15. Leuchtdiodenchip nach einem der Ansprüche 13 oder 14,
wobei die Vertiefungen (21, 22) eine Randvertiefung (22) umfassen, die einer Seitenflanke des Leuchtdiodenchips zugewandt ist, und wobei der Trennsteg (91) zwischen der Randvertiefung (22) und einer Seitenflanke des Leuchtdiodenchips (1) angeordnet ist.

16. Leuchtdiodenchip nach einem der Ansprüche 13 oder 14,
wobei die Vertiefungen (21, 22) eine Randvertiefung umfassen, die einer Seitenflanke des Leuchtdiodenchips (1) zugewandt ist, und wobei der Trennsteg (91) in der Randvertiefung (22) angeordnet ist.

## Claims

1. An LED chip (1), comprising
- a carrier (10),
- a semiconductor layer sequence (2),
- a reflective layer sequence arranged in regions between the carrier (10) and the semiconductor layer sequence (2), and
- an encapsulating layer (9) which is arranged in places between the carrier (10) and the reflective layer sequence (8),
**characterized in that**
- the reflective layer sequence (8) comprises a dielectric layer (83) facing the semiconductor layer sequence (2) and a metallic mirror layer (81) facing away from the semiconductor layer sequence (2), and
- the encapsulating layer (9) extends in places through the reflective layer sequence (8) into the semiconductor layer sequence (2) and thus forms a separating web (91) which separates an inner region (51) of the reflective layer sequence (8) from an edge region of the reflective layer sequence (8).

2. The LED chip according to claim 1,
wherein the separating web (91) completely encloses the inner region (51) so that the inner region (51) does not adjoin the edge region (52) at any point.

3. The LED chip according to one of the preceding claims,
wherein an adhesive layer (82) is disposed between the metallic mirror layer (81) and the dielectric layer (83).

4. The LED chip according to one of the preceding claims,
wherein the adhesive layer (82) comprises a transparent conductive oxide.

5. The LED chip according to one of the preceding claims,
wherein the semiconductor layer sequence comprises a current spreading layer (7) disposed on a side of the semiconductor layer sequence (2) facing the reflective layer sequence (8), the current spreading layer (7) being severed by the separating web (91).

6. The LED chip according to claim 5,
wherein the current spreading layer (7) is based on AlGaAs or GaP.

7. The LED chip according to one of the preceding claims,
wherein the encapsulating layer (9) is a metallic layer.

8. The LED chip according to one of the preceding claims,
wherein the encapsulating layer (9) comprises at least one of the metals Ti, Au, Pt, Ni, W or at least one compound with at least one of these metals.

9. The LED chip according to one of the preceding claims,
wherein the encapsulating layer (9) comprises a Ti layer facing the semiconductor layer sequence (2).

10. The LED chip according to one of claims 1 to 6,
wherein the encapsulating layer (9) is a dielectric layer.

11. The LED chip according to claim 10,
wherein the encapsulating layer (9) comprises Al₂O₃.

12. The LED chip according to claim 10 or 11,
wherein the encapsulating layer (9) is formed by atomic layer deposition.

13. The LED chip according to one of the preceding claims,
wherein the semiconductor layer sequence (2) has recesses (21, 22) on a side facing the carrier (10), the cross-section of the recesses increasing in the direction of the carrier (10) .

14. The LED chip according to claim 13,
wherein the recesses (21, 22) have a prism-shaped cross-section.

15. The LED chip according to one of claims 13 or 14,
wherein the recesses (21, 22) comprise an edge recess (22) facing a side flank of the light emitting diode chip, and wherein the separating web (91) is disposed between the edge recess (22) and a side flank of the light emitting diode chip (1) .

16. The LED chip according to one of claims 13 or 14,
wherein the recesses (21, 22) comprise an edge recess facing a side flank of the light emitting diode chip (1), and wherein the separating web (91) is arranged in the edge recess (22).

## Revendications

1. Puce de diode électroluminescente (1) dotée d'
- un support (10),
- une succession de couches semi-conductrices (2),
- une succession de couches réfléchissante agencée par endroits entre le support (10) et la succession de couches semi-conductrices (2), et
- une couche d'encapsulation (9) agencée en partie entre le support (10) et la succession de couches réfléchissante (8), **caractérisée en ce que**
- la succession de couches réfléchissante (8) présente une couche diélectrique (83) tournée vers la succession de couches semi-conductrices (2) et une couche miroir (81) métallique tournée dans le sens opposé à ladite succession de couches semi-conductrices (2), et
- la couche d'encapsulation (9) traverse en partie la succession de couches réfléchissante (8) pour aboutir dans la succession de couches semi-conductrices (2) et forme de cette façon un cloisonnement (91) séparant une zone intérieure (51) de ladite succession de couches réfléchissante (8) et une zone périphérique (52) de ladite succession de couches réfléchissante (8).

2. Puce de diode électroluminescente selon la revendication 1,
le cloisonnement (91) entourant entièrement la zone intérieure (51) de sorte que ladite zone intérieure (51) n'est adjacente en aucun point à la zone périphérique (52).

3. Puce de diode électroluminescente selon l'une quelconque des revendications précédentes, une couche adhésive (82) étant agencée entre la couche miroir métallique (81) et la couche diélectrique (83).

4. Puce de diode électroluminescente selon l'une quelconque des revendications précédentes, la couche adhésive (82) présentant un oxyde transparent conducteur.

5. Puce de diode électroluminescente selon l'une quelconque des revendications précédentes, la succession de couches semi-conductrices comprenant une couche d'étalement de courant (7) agencée sur une face de la succession de couches semi-conductrices (2) tournée vers la succession de couches réfléchissante (8), ladite couche d'élargissement de courant (7) étant sectionnée par le cloisonnement (91).

6. Puce de diode électroluminescente selon la revendication 5,
la couche d'étalement de courant (7) étant à base de AlGaAs ou de GaP.

7. Puce de diode électroluminescente selon l'une quelconque des revendications précédentes, la couche d'encapsulation (9) étant une couche métallique.

8. Puce de diode électroluminescente selon l'une quelconque des revendications précédentes, la couche d'encapsulation (9) présentant au moins un des métaux Ti, Au, Pt, Ni, W ou au moins un composé d'au moins un de ces métaux.

9. Puce de diode électroluminescente selon l'une quelconque des revendications précédentes, la couche d'encapsulation (9) comprenant une couche de Ti qui est tournée vers la succession de couches semi-conductrices (2).

10. Puce de diode électroluminescente selon l'une quelconque des revendications 1 à 6, la couche d'encapsulation (9) étant une couche diélectrique.

11. Puce de diode électroluminescente selon la revendication 10,
la couche d'encapsulation (9) présentant de l'Al₂O₃.

12. Puce de diode électroluminescente selon la revendication 10 ou 11,
la couche d'encapsulation (9) étant réalisée par dépôt de couche atomique.

13. Puce de diode électroluminescente selon l'une quelconque des revendications précédentes, la succession de couches semi-conductrices (2) présentant, sur une face tournée vers le support (10), des renfoncements (21, 22) dont la section droite va en s'accroissant dans le sens tourné vers ledit support (10).

14. Puce de diode électroluminescente selon la revendication 13, les renfoncements (21, 22) présentant une section droite en forme de prisme.

15. Puce de diode électroluminescente selon l'une quelconque des revendications 13 ou 14,
les renfoncements (21, 22) comprenant un renfoncement périphérique (22) tourné vers un flanc latéral de la puce de diode électroluminescente, et le cloisonnement (91) étant agencé entre ledit renfoncement périphérique (22) et un flanc latéral de la puce de diode électroluminescente (1) .

16. Puce de diode électroluminescente selon l'une quelconque des revendications 13 ou 14,
les renfoncements (21, 22) comprenant un renfoncement périphérique tourné vers un flanc latéral de la puce de diode électroluminescente (1), et le cloisonnement (91) étant agencé dans ledit renfoncement périphérique (22).
